# EUROPEAN PATENT APPLICATION

(11) **EP 1 768 480 A1**
(43) Date of publication of application: **28.03.2007**
(21) Application number: 06120326.1
(22) Date of filing: 07.09.2006
(51) Int. Cl.: H05K 13/00, B23Q 1/62, B60L 13/03, B60V 3/02, H01L 21/68

(54) **Device to orient a supporting plate with respect to a plurality of axes**

(30) Priority: 26.09.2005 IT UD20050159
(71) Applicant: Baccini, Gisulfo, 31030 Mignagola Di Carbonera (TV) (IT)
(72) Inventor: Baccini, Gisulfo, 31030 Mignagola Di Carbonera (TV) (IT)
(74) Representative: Petraz, Gilberto Luigi

(57) **Abstract**

Device (10) to orient on several axes a supporting plate (12) with respect to a fixed base (14). The device (10) comprises at least two linear motors (25, 26, 27) interposed between the base (14) and the supporting plate (12), wherein a first linear motor (26) is able to cause a movement of the supporting plate (12) along a first axis (X) and the other two linear motors (25, 27) are able to cause a movement of the supporting plate (12) along a second axis (Y).

## Description

### FIELD OF THE INVENTION

The present invention concerns a device to orient, on several axes, a supporting plate with respect to a fixed base. The invention is advantageously but not exclusively applied in the production of multi-layer electronic circuits of the type consisting of a plurality of elementary circuits each of which is made, in turn, on a base support, also known as greentape®, which is disposed on the plate.

### BACKGROUND OF THE INVENTION

In the field of production of electronic circuits, particularly multi-layer circuits, it is known, as described in the Italian patent of industrial invention IT-B-1310557 granted on 18.02.2002 in the name of the present Applicant, to use elementary circuits each made on a base support, comprising one or more sheets of insulating material, consisting of aluminum, or synthetic materials, and also called greentape®.

In the course of the various working steps, each base support is moved from one work station to another and, in each of them, is disposed on a supporting plate, which must be oriented with micrometric precision, on various axes, with respect to a fixed base.

In order to orient the supporting plate with respect to the base, orientation devices are known, comprising several electric motors disposed outside the supporting plate and mechanically connected thereto by means of mechanical transmission members such as arms, shafts, pulleys and reduction gears. Said known devices are structurally very complex, however, they have considerable bulk, and do not allow to achieve a precise and repeatable micrometric orientation of the supporting plate, and therefore to obtain great precision in the final product.

A purpose of the present invention is to achieve a device to orient on several axes a supporting plate with respect to a fixed base, which allows good precision in the orientation or positioning of the plate in order to obtain good repeatability of the product and narrow working tolerances.

The Applicant has devised, tested and embodied the present invention to overcome the shortcomings of the state of the art and to obtain these and other purposes and advantages.

### SUMMARY OF THE INVENTION

The present invention is set forth and characterized in the main claim, while the dependent claims describe other characteristics of the invention or variants to the main inventive idea.

In accordance with the above purpose, a device according to the invention is able to be used to orient on several axes a supporting plate with respect to a fixed base.

An object on which a determinate process is then carried out is able to be disposed on said plate.

According to a characteristic of the present invention, the device comprises at least two linear motors interposed between the base and the supporting plate, wherein at least a first of the linear motors is able to cause a movement of the supporting plate along a first axis "X" and at least a second motor is able to cause a movement of the supporting plate along a second axis "Y".

In a preferential form of embodiment, the axis "X" and the axis "Y" are orthogonal to each other and lie on a plane of orientation which is parallel to the supporting surface of the supporting plate.

Moreover, each of said linear motors comprises a fixed element, or stator, solid with the base, and a mobile element, or cursor, facing the stator and solid with the supporting plate.

The movements to which the supporting plate is subjected are substantially independent of each other and allow to translate said plate with respect to the base, both along the axis "X" and also along the axis "Y", by any determinate entity.

Moreover, the use of the linear motors allows to eliminate every mechanical transmission member, such as arms, shafts, pulleys or reduction gears, which are typical of known devices, and allows both to obtain greater precision and also to considerably reduce the bulk and complexity of the device according to the invention.

According to a preferential form of embodiment of the invention, between the fixed base and the supporting plate at least a third linear motor is interposed which, driven together with at least one of the other two, is able to cause a rotation of the supporting plate with respect to a third axis "θ" substantially orthogonal to the plane of orientation.

In this way, the device according to the present invention is able to orient, with extreme precision, the supporting plate with respect to at least three axes (X, Y, θ).

According to an advantageous embodiment, in order to reduce to a minimum the friction between the supporting plate and the base, the device comprises ball means, mounted on the base, on which the supporting plate is rested and is free to move.

Moreover, a sensor means is advantageously provided to detect the position with respect to the base of the supporting plate, and hence the object disposed thereon.

The sensor means is connected to a control unit, able to process the signals emitted by said sensor means in order to control and drive the linear motors.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a plane view, partly sectioned, of a device according to the present invention to orient on several axes a supporting plate with respect to a fixed base;
- fig. 2 is a lateral section from II to II of the device in fig. 1;
- fig. 3 is a lateral section from III to III of the device in fig. 1;
- fig. 4 is an enlarged detail of fig. 2.

### DETAILED DESCRIPTION OF A PREFERENTIAL FORM OF EMBODIMENT

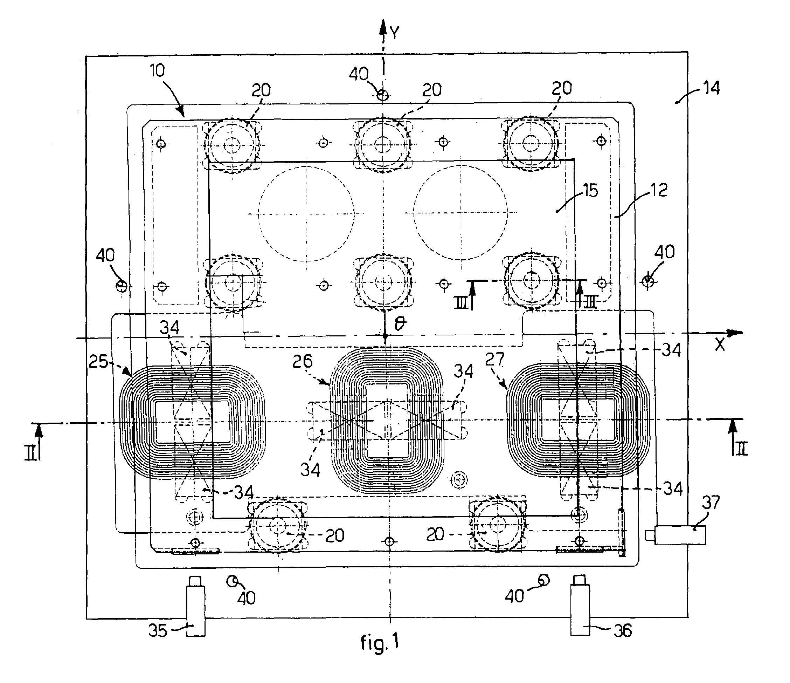

With reference to fig. 1, a device 10 according to the invention to orient on several axes a supporting plate 12 with respect to a fixed base 14 is usable for example in the production of electronic circuits.

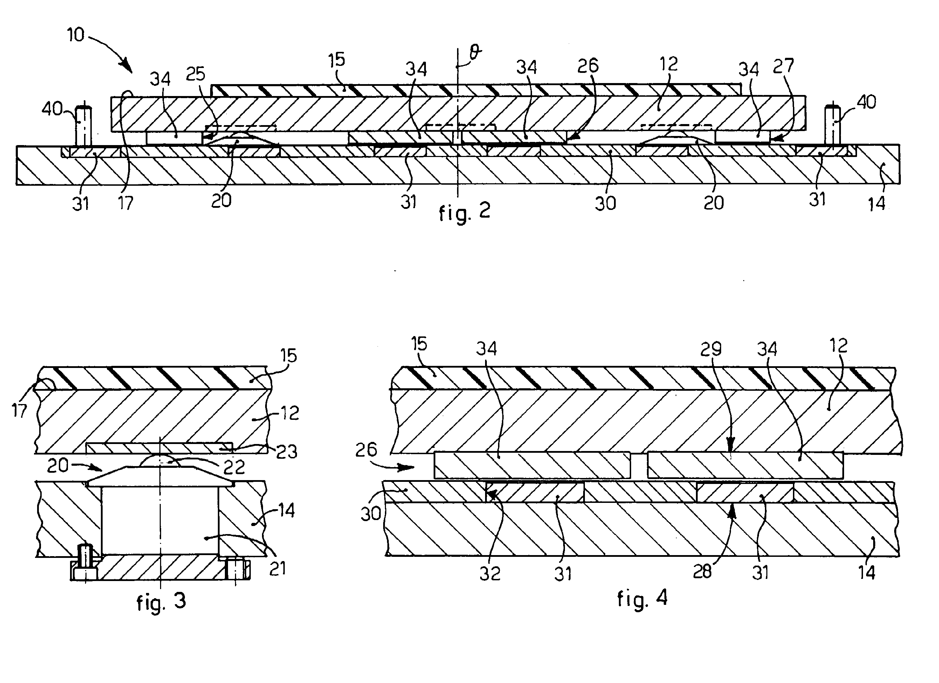

To be more exact, the supporting plate 12 (figs. 1 and 2) has a plane upper surface 17 on which a base support 15 is able to be disposed, on which a printing station, not shown here and solid with the base 14, is able to dispose tracks of electrically conducting material.

The supporting plate 12 is made of rigid material, for example aluminum, and is shaped substantially like a parallelepiped, with sizes of about 400 mm by about 370 mm and with a thickness of about 20 mm.

The base support 15 consists for example of one or more flexible and very thin sheets, in the order of some tenths of a millimeter, of insulating material, such as aluminum or plastic material, and also known as greentape®.

The supporting plate 12 is connected to the base 14 by means of a plurality of supports 20, in this case eight, each comprising a base 21 (fig. 3) fixed to the base 14 itself and having a substantially semi-spherical seating where a ball 22 is inserted, free to rotate. The supporting plate 12 comprises, in turn, eight inserts 23 made for example of widia, or other material with similar characteristics of hardness, each of which rests on a respective ball 22. The points where the inserts 23 rest on the balls 22 define a substantially horizontal plane, with respect to which the supporting plate 12 is free to move.

The device 10 according to the present invention comprises three linear motors (figs. 1 and 2), respectively first 25, second 26 and third 27, positioned between the base 14 and the supporting plate 12 and each comprising a stator 28 (fig. 4), fixed to the base 14, and a cursor 29, fixed to the supporting plate 12.

The base 14 comprises, facing towards the supporting plate 12, a shaped plate 31 including seatings 32, inside each of which a respective electric coil 31 of the stator 28 is inserted, substantially flush with the upper surface of the shaped plate 30.

Each cursor 29 comprises two permanent magnets 34 aligned with each other and along a longitudinal axis, and facing each other on one side of said coil 31.

The first and the third motor 25 and 27 are mounted so that the longitudinal axes of the magnets 34 of the respective cursors 29 are parallel to each other and parallel to an axis Y of the supporting plate 12 (fig. 1).

The second motor 26 is disposed so that the longitudinal axis of the magnets 34 of the cursor 29 is substantially orthogonal to that of the magnets 34 of the cursor 29 of the first and third motor 25 and 27 and is parallel to an axis X of the supporting plate 12 and therefore orthogonal to the axis Y.

In this way, when the second motor 26 is energized, the supporting plate 12 moves along the axis X and, according to the energizing mode, moves to the right or to the left.

By energizing the first and the third motor 25 and 27 with the same energizing mode, the supporting plate 12 moves along the axis Y, whereas, by varying the energizing mode in both motors 25 and 27, the supporting plate 12 moves along the axis Y in the direction opposite the previous one.

Moreover, by energizing the first and the third motor 25 and 27 with different energizing modes, the supporting plate 12 rotates in said plane defined by the balls 22 of the supports 20 with respect to an axis θ, in a clockwise or anti-clockwise direction, according to the energizing mode itself.

The device 10 also comprises three sensors, respectively first 35, second 36 and third 37 (fig. 1), for example of the optical type, two of which are fixed to the same side of the base 14 and the third 37 to an adjacent side. According to a variant not shown here, the sensors 35, 36 and 37 are of the feeler type. The sensors 35, 36 and 37 are able to detect the distance from the outer edge of the plate 12.

The device 10 also comprises a command and control unit, of a known type and not shown here, which based on the data detected by the three sensors 35, 36 and 37 commands the three motors 25, 26 and 27 so as to move and orient the supporting plate 12 and center the base support 15 with respect to the base 14 and hence with respect to the printing device.

The three sensors 35, 36 and 37, in cooperation with the command and control unit, allow to achieve an accuracy of orientation of about 0.5 µm.

Once the correct position of the supporting plate 12 with respect to the base 14 has been identified, the plate 12 is clamped to the base 14 by means of clamping means, not shown, for example a clamp, or by suitably energizing the linear motors 25, 26 and 27.

According to one embodiment of the invention, the base 14 comprises a plurality of cylindrical elements 40 disposed in correspondence with each of the four sides of the supporting plate 12, elements 40 that function as a containing frame and as security against possible additional travels of the plate 12.

It is clear that modifications and/or additions of parts may be made to the device 10 as described heretofore, without departing from the field and scope of the present invention.

According to a variant of the invention, the first and the third motor 25 and 27 are disposed in the central zone of the base 14, substantially aligned with the axis X.

It is also clear that, although the present invention has been described with reference to some specific examples, a person of skill in the art shall certainly be able to achieve many other equivalent forms of device to orient on several axes a supporting plate, having the characteristics as set forth in the claims and hence all coming within the field of protection defined thereby.

## Claims

1. Device to orient on several axes a supporting plate (12) with respect to a fixed base (14), **characterized in that** it comprises at least two linear motors (25, 26, 27) interposed between said base (14) and said supporting plate (12), wherein at least a first linear motor (26) is able to cause a movement of said supporting plate (12) along a first axis (X) and wherein at least a second linear motor (25, 27) is able to cause a movement of said supporting plate (12) along a second axis (Y).

2. Device as in claim 1, **characterized in that** said first axis (X) and said second axis (Y) are substantially orthogonal to each other.

3. Device as in claim 1 or 2, **characterized in that** it also comprises at least a third linear motor (27, 25) which is interposed between said base (14) and said supporting plate (12) and which, driven together with said first and/or said second linear motor (25, 26, 27) is able to cause a rotation of said supporting plate (12) with respect to a third axis (θ) substantially orthogonal to said first axis (X) and said second axis (Y).

4. Device as in claim 1, 2 or 3, **characterized in that** it also comprises sensor means (35, 36, 37) associated with said base (14) and able to detect the position of said supporting plate (12) with respect to said base (14).

5. Device as in claim 4, **characterized in that** it also comprises a control unit connected to said sensor means (35, 36, 37) and able to control and selectively drive said linear motors (25, 26, 27).

6. Device as in any claim hereinbefore, **characterized in that** it comprises ball means (22) associated with said base (14) on which said supporting plate (12) rests, free to move.

7. Device as in any claim hereinbefore, **characterized in that** each of said linear motors (25, 26, 27) comprises at least a fixed element (28) associated with said base (14) and at least a mobile element (29) associated with said supporting plate (12), wherein said fixed and mobile elements (28, 29) face each other.

8. Device as in claim 7, **characterized in that** said fixed element (28) comprises at least an electric coil (31) and said mobile element (29) comprises one or more permanent magnets (34).

9. Device as in claim 7 or 8, **characterized in that** shaped seatings (32) are made on said base (14), inside each of which a respective fixed element (28) is inserted.
